# EUROPEAN PATENT APPLICATION

(11) **EP 4 696 538 A1**
(43) Date of publication of application: **18.02.2026**
(21) Application number: 25766864.0
(22) Date of filing: 14.04.2025
(51) Int. Cl.: B60L 3/00, B60L 15/20, B60R 16/03, G01M 17/007

(54) **SAFE POWER SUPPLY CONTROL SYSTEM AND METHOD FOR RANGE-EXTENDED ELECTRIC TEST VEHICLE**

(30) Priority: 26.06.2024 CN 202410838761
(71) Applicant: Chery Automobile Co., Ltd., Wuhu, Anhui 241006 (CN)
(72) Inventor: GE, Dongyun, Wuhu, Anhui 241006 (CN); ZHANG, Bibo, Wuhu, Anhui 241006 (CN); WANG, Jianan, Wuhu, Anhui 241006 (CN)
(74) Representative: Yang, Shu
(86) International application number: PCT/CN2025/088812
(87) International publication number: WO 2026/001204

(57) **Abstract**

A system and method for controlling safe power supply of a range-extended electric vehicle test vehicle are proposed, which relates to the technical field of safe power supply for test vehicles. The system includes an emergency stop switch disposed on a low-voltage power supply line of the test vehicle. The low-voltage power supply line is configured to supply power to a vehicle control unit and a battery management system of the test vehicle. The emergency stop switch is configured to, when actuated, cut off power supply from the low-voltage power supply line to the vehicle control unit and the battery management system. By adding the emergency stop switch between the low-voltage power supply line and the vehicle control unit and the battery management system and using the added emergency stop switch as a safety protection device, in the event of leakage or the power output cannot be cut off through signal control, the emergency stop switch can be pressed, combined with a high-voltage interlocking strategy, to cut off the external power supply of the battery pack of the test vehicle , thereby achieving safe and reliable cutting off of high-voltage power output, thereby ensuring the safety of the test personnel and improving the safety and reliability of the test vehicle.

## Description

This disclosure is based on a Chinese patent application filed on June 26, 2024, with application number 202410838761.8, and entitled "SYSTEM AND METHOD FOR CONTROLLING SAFE POWER SUPPLY OF RANGE-EXTENDED ELECTRIC VEHICLE TEST VEHICLE", and claims the priority of the Chinese patent application. The entire contents of the Chinese patent application are hereby incorporated into this disclosure as a reference.

### TECHNICAL FIELD

The present application belongs to the technical field of safe power supply for test vehicles, and in particular to a system and method for controlling safe power supply of a range-extended electric vehicle test vehicle.

### BACKGROUND OF THE INVENTION

Compared with traditional vehicles, range-extended electric vehicles have added high-voltage power or power supply equipment such as motors, motor control units, generators, generator control units, DC/DC (Direct Current to Direct Current Converter), high-voltage battery packs, compressors, etc. Therefore, the safety protection of the vehicle's high-voltage system is very important. In the existing technology, there are industry standards for this part of high-voltage power or power supply equipment, which stipulate that the high-voltage components on electric vehicles should have a high-voltage interlocking device. High-voltage interlock is also referred to as high-voltage interlock loop (abbreviated as HVIL). The vehicle uses high-voltage interlock to detect the integrity and continuity of the entire high-voltage system circuit and can promptly disconnect the control electrical components at the high-voltage input end.

Before a vehicle is released to the market, it typically undergoes multiple tests using test vehicles. However, since range-extended electric vehicle test vehicles use high-voltage battery packs for power, any leakage during testing could endanger the safety of the test personnel.

### SUMMARY OF THE INVENTION

In order to overcome the deficiencies of the above-mentioned prior art, the present application provides a system and method for controlling safe power supply of a range-extended electric vehicle test vehicle, which can effectively solve the high-voltage leakage problem that may exist in the range-extended electric vehicle test vehicle during the test, as well as the power output out-of-control problem caused by the immaturity of the test vehicle software system, thereby greatly improving the safety and reliability of the test vehicle.

To achieve the above-mentioned objectives, in a first aspect of the present application, a system for controlling safe power supply of a range-extended electric vehicle test vehicle is provided. The system includes an emergency stop switch disposed on a low-voltage power supply line of the test vehicle, in which the low-voltage power supply line is configured to supply power to a vehicle control unit and a battery management system of the test vehicle, and the emergency stop switch is configured to, when actuated, cut off power supply from the low-voltage power supply line to the vehicle control unit and the battery management system.

In some embodiments, the vehicle control unit is configured to acquire a low-frequency voltage signal from the low-voltage power supply line, and upon determining that the low-frequency voltage signal is abnormal, control the test vehicle to perform high-voltage shutdown.

In some embodiments, the vehicle control unit is communicatively coupled to a motor control unit and a generator control unit of the test vehicle, the motor control unit is communicatively coupled to a motor of the test vehicle, and the generator control unit is communicatively coupled to a generator of the test vehicle.

In some embodiments, the vehicle control unit is further configured to control the motor control unit and the generator control unit to operate in a normal manner upon determining that the low-frequency voltage signal is normal.

In some embodiments, the battery management system is configured to acquire a low-frequency voltage signal from the low-voltage power supply line, and upon determining that the low-frequency voltage signal is abnormal, disconnect a battery pack relay of the test vehicle to cut off a connection between a power battery of the test vehicle and a high-voltage wiring harness of the test vehicle.

In some embodiments, the battery management system is further configured to maintain a closed state of the battery pack relay to maintain the connection between the power battery and the high-voltage wiring harness upon determining that the low-frequency voltage signal is normal.

In some embodiments, the low-voltage power supply line is further configured to supply power to an engine management system of the test vehicle; and the vehicle control unit, the battery management system, and the engine management system are all disposed downstream of the emergency stop switch.

In some embodiments, a key switch KL15 is also disposed on the low-voltage power supply line, the key switch KL15 is disposed upstream of the emergency stop switch, and the key switch KL15 is configured to control power supply of the low-voltage power supply line.

In a second aspect of the present application, a method for controlling safe power supply of a range-extended electric vehicle test vehicle is provided. The method includes:
when the test vehicle is in operation and an emergency stop switch of the test vehicle is switched from a closed state to an open state, acquiring, by a vehicle control unit of the test vehicle, a low-frequency voltage signal from a low-voltage power supply line of the test vehicle, and upon determining that the low-frequency voltage signal is abnormal, controlling the test vehicle to perform high-voltage shutdown, and controlling a motor control unit and a generator control unit of the test vehicle to respectively control a motor and a generator of the test vehicle to stop operating; and
when the test vehicle is in operation and the emergency stop switch of the test vehicle is switched from a closed state to an open state, acquiring, by a battery management system of the test vehicle, a low-frequency voltage signal from the low-voltage power supply line, and upon determining that the low-frequency voltage signal is abnormal, disconnecting a battery pack relay of the test vehicle to cut off a connection between a power battery of the test vehicle and a high-voltage wiring harness of the test vehicle.

In some embodiments, the method further includes:
when the test vehicle is started and the emergency stop switch is in an open state, disconnecting, by the emergency stop switch, the low-voltage power supply line, and determining, by the vehicle control unit, that the low-frequency voltage signal is abnormal upon receiving no low-frequency voltage signal, and preventing the vehicle control unit from performing a preparatory operation and a high-voltage power-up operation; and
when the test vehicle is started and the emergency stop switch is in an open state, disconnecting, by the emergency stop switch, an interlock loop of a high-voltage line of the test vehicle, and determining, by the battery management system, that the low-frequency voltage signal is abnormal upon receiving no low-frequency voltage signal returned by the interlock loop, and preventing the vehicle control unit from performing a preparatory operation and a high-voltage power-up operation.

One or more of the above technical solutions have the following beneficial effects:
The present application provides a system for controlling safe power supply of a range-extended electric vehicle test vehicle. In response to the high-voltage leakage that may occur during the test of the range-extended electric vehicle test vehicle, as well as the power output out-of-control caused by the signal control method due to the immaturity of the test vehicle's software system, an emergency stop switch is added to the low-voltage power supply line based on the actual situation of the test vehicle. By opening or closing the emergency stop switch, the vehicle control unit can identify the change in the status of the low-voltage power supply line, and then control the test vehicle to power up or down at high voltage. In this way, in the event of a high-voltage leakage or out-of-control of signal-controlled power output of the test vehicle, the test vehicle can be quickly powered down by pressing the emergency stop switch, thereby ensuring the safety of the test vehicle. In addition, the battery management system of the test vehicle will also identify the status of the low-voltage power supply line based on this, and then control whether to cut off the connection between the power battery and the high-voltage wiring harness. In this way, if there is a problem with the entire high-voltage system circuit, the control electrical components at the high-voltage input end can be disconnected in time, thereby ensuring the safety of the test vehicle.

The logic of the present application is simple. Without changing the original connection lines of the test vehicle, the purpose of quickly controlling the battery pack to stop power supply and cut off power output can be achieved by adding an emergency stop switch. The cost is low, the results are reliable, and the safety of the test vehicle is improved. When the test vehicle is in danger, the safety of the test personnel can be well guaranteed.

### BRIEF DESCRIPTION OF DRAWINGS

The drawings in the specification, which constitute a part of the present application, are intended to provide further understanding of the present application. The illustrative embodiments of the present application and their descriptions are intended to explain the present application and do not constitute improper limitations on the present application.

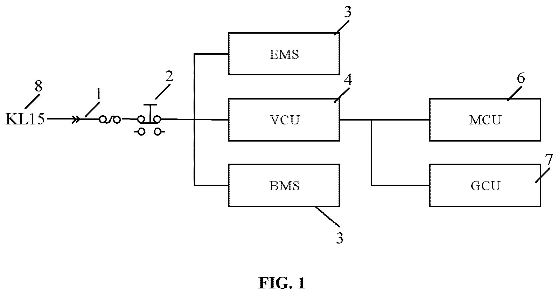

FIG1 is a system structure diagram of a first embodiment.

In the accompanying drawings, the components represented by the reference numerals are as follows:
1 low-voltage power supply line, 2 emergency stop switch, 3 engine management system (EMS), 4 vehicle control unit (VCU), 5 battery management system (BMS), 6 motor control unit (MCU), 7 generator control unit (GCU), 8 key switch KLL15.

### DETAILED DESCRIPTION

It should be noted that the following detailed descriptions are exemplary and are intended to provide further explanation of the present application. Unless otherwise specified, all technical and scientific terms used herein have the same meaning as commonly understood by those skilled in the art to which the present application belongs.

It should be noted that the terms used herein are only for describing specific embodiments and are not intended to limit the exemplary embodiments according to the present application.

In the absence of conflict, the embodiments of the present application and the features in the embodiments can be combined with each other.

Before a vehicle is released to the market, it typically undergoes multiple tests using test vehicles. However, since range-extended electric vehicle test vehicles use high-voltage battery packs for power, any leakage during testing could endanger the safety of the test personnel, including the following issues.
1. Range-extended electric vehicles are powered by high-voltage battery packs, with a voltage of up to 400V. The test vehicle may have leakage, which is likely to endanger the safety of the test personnel.
2. Compared with traditional fuel vehicles, the power output control of range-extended electric vehicles is signal-controlled, and the power output cannot be cut off mechanically. In addition, the test vehicle software system is immature and contains errors. Once a problem occurs in the software system, the test personnel will fail to stop the range-extended electric vehicle test vehicle, which will cause the test vehicle to lose control and endanger the safety of the test personnel.

Therefore, the embodiments of the present application provide a system and method for controlling safe power supply of a range-extended electric vehicle test vehicle to address the above-mentioned problems.

### First Exemplary Embodiment

The present application provides a solution to the high-voltage leakage problem that may exist in the range-extended electric vehicle test vehicle during the test, and the power output out-of-control problem of the signal control method caused by the immaturity of the test vehicle software system. By adding an emergency stop switch 2 between a low-voltage power supply line and an engine management system 3, a vehicle control unit 4, and a battery management system 5, the added emergency stop switch 2 is used as a safety protection device. When leakage occurs and the power output cannot be cut off through signal control, the emergency stop switch 2 can be pressed, combined with a high-voltage interlocking strategy, to cut off the external power supply of the battery pack, thereby achieving safe and reliable cutting off of the high-voltage power output, so as to ensure the safety of the test personnel and improve the safety and reliability of the test vehicle.

Please refer to FIG. 1, which is a connection diagram of a system for controlling safe power supply for a range-extended electric vehicle test vehicle provided in the present application.

As a specific embodiment provided in the present application, the system for controlling safe power supply for a range-extended electric vehicle test vehicle includes an emergency stop switch 2 disposed on a low-voltage power supply line 1 of the test vehicle. The low-voltage power supply line 1 is configured to supply power to a vehicle control unit 4 and a battery management system 5 of the test vehicle respectively. The emergency stop switch 2 is configured to, when actuated, cut off power supply from the low-voltage power supply line 1 to the vehicle control unit 4 and the battery management system 5.

A first end of the low-voltage power supply line 1 is electrically connected to a low-voltage power supply source, and a second end of the low-voltage power supply line 1 is electrically connected to the vehicle control unit 4 and the battery management system 5 respectively.

The test vehicle is equipped with both low-voltage and high-voltage power supply lines. The voltage on the low-voltage power supply line is generally lower than that on the high-voltage power supply line. For example, the voltage on the low-voltage power supply line is generally 12V or 24V, while the voltage on the high-voltage power supply line is generally 60V. The low-voltage power supply line is mainly configured to supply power to low-voltage components on the test vehicle, such as audio components and lighting components.

The high-voltage power supply line is mainly configured to supply power to high-voltage components on the test vehicle, such as electric motors, high-voltage control units, etc.

By adding the emergency stop switch 2 to the test vehicle, the emergency stop switch 2 is disposed on the low-voltage power supply line 1 connected to the vehicle control unit 4 and the battery management system 5. When leakage occurs and the power output cannot be cut off through signal control, the emergency stop switch 2 can be pressed and combined with a high-voltage interlocking strategy to cut off the external power supply of the battery pack, further ensuring the personal safety of the test personnel on the test vehicle and improving the reliability of the test vehicle.
(1) The vehicle control unit 4 performs a logic judgment process for the safe power supply of the range-extended electric vehicle test vehicle, including:
   The vehicle control unit 4 acquires a low-frequency voltage signal from the low-voltage power supply line 1, and controls the test vehicle to perform high-voltage shutdown upon determining that the low-frequency voltage signal is abnormal;
   The vehicle control unit 4 also controls a motor control unit 6 and a generator control unit 7 to operate in a normal manner upon determining that the low-frequency voltage signal is normal.

The vehicle control unit 4 is communicatively coupled to the motor control unit 6 and the generator control unit 7 of the test vehicle, the motor control unit 6 is communicatively coupled to a motor of the test vehicle, and the generator control unit 7 is communicatively coupled to a generator of the test vehicle. The motor control unit 6 controls the operation of the motor, and the generator control unit 7 controls the operation of the generator.

The emergency stop switch 2 is connected to the vehicle control unit 4 through the low-voltage power supply line 1, triggering the test vehicle's low-voltage protection function. The vehicle control unit 4 determines the status of the low-voltage power supply line 1 using feedback from the low-frequency voltage signal, specifically whether the low-voltage circuit has any abnormality. The low-voltage power supply line 1 is connected to the test vehicle's main control unit and the vehicle control unit 4, forming a low-voltage circuit.

When a short circuit, interruption, or control unit failure occurs in the low-voltage circuit, the low-frequency voltage signal will be interrupted or the signal frequency will change. The vehicle control unit 4 will then determine that the test vehicle is abnormal and that the current condition affects driving safety, and will issue a signal to control the test vehicle to stop the preparatory operation or control the vehicle to perform high-voltage shutdown.

In this embodiment, after the emergency stop switch 2 is added, when the test personnel presses the emergency stop switch 2 during the operation of the test vehicle, the low-voltage circuit is in an open-circuit state. At this time, the low-frequency voltage signal in the low-voltage power supply line 1 is interrupted, and the vehicle control unit 4 can no longer acquire the low-frequency voltage signal. Therefore, the vehicle control unit 4 determines that an abnormality has occurred and then controls the test vehicle to perform high-voltage shutdown. Powering down at high voltage refers to disconnecting the main relay in the high-voltage system, thereby disconnecting the high-voltage circuit.

After the vehicle-wide high-voltage shutdown is performed, the vehicle control unit 4 will control the motor control unit 6 and generator control unit 7 signally connected thereto, so that the motor control unit 6 and the generator control unit stop controlling the continued operation of the motor and generator respectively, thereby effectively cutting off the power output of the test vehicle.

(2) The battery management system 5 performs a logic judgment process for the safe power supply of the range-extended electric vehicle test vehicle, including:
The battery management system 5 acquires a low-frequency voltage signal from the low-voltage power supply line 1 and, upon determining that the low-frequency voltage signal is abnormal, disconnects a battery pack relay of the test vehicle to cut off a connection between a power battery of the test vehicle and a high-voltage wiring harness of the test vehicle;
When determining that the low-frequency voltage signal is normal, the battery management system 5 maintains the closed state of the battery pack relay to maintain the connection between the power battery and the high-voltage wiring harness.

The logical judgment process of the above-mentioned battery management system 5 for the safe power supply of the range-extended electric vehicle test vehicle is similar to that of the vehicle control unit 4. The emergency stop switch 2 is connected to the battery management system 5 through the low-voltage power supply line 1, triggering the high-voltage protection function of the test vehicle, that is, in the event of an abnormality in the low-voltage circuit, it can promptly cut off the connection between the power battery of the test vehicle and the high-voltage wiring harness to stop the power battery from outputting electrical energy.

Furthermore, the battery management system 5 in this embodiment is still equipped with a high-voltage interlock loop, which is configured to detect faults such as poor connection in the high-voltage line. Each connector in the high-voltage line has an interlock socket and a shorting pin. The battery management system 5 sends out a low-frequency voltage signal. Under normal conditions, this signal passes through the interlock loops of all high-voltage wiring harness plugs and returns to the battery management system 5.

The battery management system 5 monitors the status of the high-voltage line. If this signal is not received, the battery management system 5determines that the vehicle's high-voltage plug has been manually unplugged or is not firmly connected. In this case, the vehicle is in a dangerous situation and enters a self-protection state. A SOC (State of Charge, the ratio of the remaining battery power to the fully charged state) signal sent out is 0, indicating that the battery is now unable to supply power to the outside. At the same time, a signal is sent to separate the relay inside the battery, thereby cutting off the high-voltage output.

Therefore, in this embodiment, the battery management system 5 can perform loop signal detection based on the two detection methods of the emergency stop switch 2 and the high-voltage interlock loop, so as to cut off the power output of the high-voltage battery pack in time based on the detection results.

In this embodiment, after the emergency stop switch 2 is added, when the test personnel presses the emergency stop switch 2 during the operation of the test vehicle, the battery management system 5 determines that a power outage has occurred. At this time, the low-frequency voltage signal will be lost, and the battery management system 5 enters a self-protection state, sending a signal that the SOC is 0, and then disconnecting the battery pack relay to cut off the connection between the battery and the high-voltage wiring harness. In this way, when the high-voltage power battery leaks, by pressing the emergency stop switch 2, the risks brought by this problem can be effectively avoided, thereby improving the personal safety of the test personnel and the reliability of the test vehicle.

Taking into account the situation of hybrid test vehicles, in this embodiment, the low-voltage power supply line 1 is further configured to supply power to the engine management system 3. Specifically, the second end of the low-voltage power supply line 1 is also electrically connected to the engine management system 3, so as to facilitate the expansion of the applicable types of test vehicles.

The detection principle of the engine management system 3 is the same as that of the above-mentioned vehicle control unit 4 and battery management system 5. It also acquires a low-frequency voltage signal from the low-voltage power supply line 1. Upon determining that the low-frequency voltage signal is abnormal, the engine of the test vehicle is controlled to stop operating and the power output is cut off; upon determining that the low-frequency voltage signal is normal, the engine of the test vehicle is controlled to continue operating normally.

In this embodiment, the vehicle control unit 4, battery management system 5, and engine management system 3 are all disposed downstream of the emergency stop switch 2, thereby enabling the emergency stop switch 2 to effectively control the vehicle control unit 4, battery management system 5, and engine management system 3. A key switch KL15 8 is also provided on the low-voltage power supply line 1. This key switch KL15 8 is disposed upstream of the emergency stop switch 2 and is configured to control power supply of the low-voltage power supply line. When the key switch KL15 8 is turned to an ON position, the key switch KL15 8 is closed, and the low-voltage power supply will supply power to the vehicle control unit 4, battery management system 5, and engine management system 3 through the low-voltage power supply line 1.

### Operating principle:

### 1. When the vehicle is started:

When the vehicle is started, it performs an ignition check. If the emergency stop switch 2 is disconnected, the low-voltage circuit is open, preventing the vehicle control unit 4 from receiving the low-frequency voltage signal. Simultaneously, the high-voltage line's interlock loop is disconnected, preventing the low-frequency voltage signal from returning to the battery management system control unit via the high-voltage interlock loop. This causes the high-voltage interlock test to fail, and the battery management system determines that the battery is faulty or dead, signaling a SOC of 0. Both of these abnormal signals prevent the vehicle control unit 4 from performing preparatory operations and from being powered up at high voltage.

### 2. When the vehicle is in operation:

When the vehicle is in operation, the emergency stop switch 2 is switched to an open state, and the low-frequency voltage signal fed back by the vehicle's main control unit to the vehicle control unit 4 will be interrupted. The vehicle control unit 4 will then determine that the vehicle's circuit is abnormal and then send a signal to control the vehicle to perform high-voltage shutdown.

At the same time, if a power outage occurs during operation, the battery management system 5 will lose the low-frequency voltage signal and enter a self-protection state. At this time, it will send a signal that the SOC is 0, disconnect the battery pack relay, and cut off the connection between the battery and the high-voltage wiring harness.

By opening or closing the emergency stop switch 2, the vehicle control unit can detect changes in the low-voltage power supply line status, thereby controlling the test vehicle to power up or perform high-voltage shutdown. Furthermore, in the event of a high-voltage leakage or out-of-control of signal-controlled power output in the test vehicle, pressing the emergency stop switch can quickly power down the test vehicle, ensuring its safety. Furthermore, the battery management system 5 also identifies the status of the low-voltage power supply line based on this information and controls whether to disconnect the battery from the high-voltage wiring harness. This solution allows for rapid control of the battery pack's power supply, stopping, or disconnecting power output, ensuring the safety of the test personnel in the event of a dangerous situation.

### Second Exemplary Embodiment

This embodiment discloses a method for controlling safe power supply of a range-extended electric vehicle test vehicle. The method includes:
When the test vehicle is in operation and the emergency stop switch 2 of the test vehicle is switched from a closed state to an open state, the vehicle control unit 4 of the test vehicle acquires a low-frequency voltage signal from the low-voltage power supply line 1. Upon determining that the low-frequency voltage signal is abnormal, the vehicle control unit 4 controls the test vehicle to perform high-voltage shutdown, and controls the motor control unit 6 and the generator control unit 7 to respectively control the motor and generator of the test vehicle to stop operating.

When the test vehicle is in operation and the emergency stop switch 2 of the test vehicle is switched from a closed state to an open state, the battery management system 5 acquires a low-frequency voltage signal from the low-voltage power supply line 1. Upon determining that the low-frequency voltage signal is abnormal, the battery pack relay of the test vehicle is disconnected to cut off the connection between the power battery and the high-voltage wiring harness, so that the power battery of the test vehicle stops outputting electrical energy.

Furthermore, when the test vehicle is started and the emergency stop switch 2 is in an open state, the emergency stop switch 2 disconnects the low-voltage power supply line 1. The vehicle control unit 4 determines that the low-frequency voltage signal is abnormal when it does not receive the low-frequency voltage signal. The vehicle control unit 4 is prevented from performing the preparatory operation and the high-voltage power-up operation.

When the test vehicle is started and the emergency stop switch is in an open state, the emergency stop switch disconnects the interlock loop of the test vehicle's high-voltage line. Without receiving the low-frequency voltage signal returned by the interlock loop, the battery management system 5 determines that the low-frequency voltage signal is abnormal, and the vehicle control unit 4 is prevented from performing the preparatory operation and the high-voltage power-up operation. In this case, because the low-frequency voltage signal cannot be returned to the battery management system 5 through the interlock loop of the high-voltage line, the battery management system 5 cannot receive the low-frequency voltage signal returned by the interlock loop.

The present application provides a system for controlling safe power supply of a range-extended electric vehicle test vehicle. In response to the high-voltage leakage that may occur during the test of the range-extended electric vehicle test vehicle, as well as the power output out-of-control caused by the signal control method due to the immaturity of the test vehicle's software system, an emergency stop switch is added to the low-voltage power supply line based on the actual situation of the test vehicle. By opening or closing the emergency stop switch, the vehicle control unit can identify the change in the status of the low-voltage power supply line, and then control the test vehicle to power up or down at high voltage. In this way, in the event of a high-voltage leakage or out-of-control of signal-controlled power output of the test vehicle, the test vehicle can be quickly powered down by pressing the emergency stop switch, thereby ensuring the safety of the test vehicle. In addition, the battery management system of the test vehicle will also identify the status of the low-voltage power supply line based on this, and then control whether to cut off the connection between the power battery and the high-voltage wiring harness. In this way, if there is a problem with the entire high-voltage system circuit, the control electrical components at the high-voltage input end can be disconnected in time, thereby ensuring the safety of the test vehicle.

The logic of the present application is simple. Without changing the original connection lines of the test vehicle, the purpose of quickly controlling the battery pack to stop power supply and cut off power output can be achieved by adding an emergency stop switch. The cost is low, the results are reliable, and the safety of the test vehicle is improved. When the test vehicle is in danger, the safety of the test personnel can be well guaranteed.

Although the specific embodiments of the present application are described in conjunction with the accompanying drawings, it does not limit the scope of protection of the present application. A person skilled in the art should understand that on the basis of the technical solution of the present application, various modifications or variations that can be made by a person skilled in the art without creative work are still within the scope of protection of the present application.

## Claims

1. A system for controlling safe power supply of a range-extended electric vehicle test vehicle, comprising an emergency stop switch disposed on a low-voltage power supply line of the test vehicle, wherein the low-voltage power supply line is configured to supply power to a vehicle control unit and a battery management system of the test vehicle; and wherein the emergency stop switch is configured to, when actuated, cut off power supply from the low-voltage power supply line to the vehicle control unit and the battery management system.

2. The system for controlling safe power supply of a range-extended electric vehicle test vehicle according to claim 1, wherein the vehicle control unit is configured to acquire a low-frequency voltage signal from the low-voltage power supply line, and upon determining that the low-frequency voltage signal is abnormal, control the test vehicle to perform high-voltage shutdown.

3. The system for controlling safe power supply of a range-extended electric vehicle test vehicle according to claim 2, wherein the vehicle control unit is communicatively coupled to a motor control unit and a generator control unit of the test vehicle, the motor control unit is communicatively coupled to a motor of the test vehicle, and the generator control unit is communicatively coupled to a generator of the test vehicle.

4. The system for controlling safe power supply of a range-extended electric vehicle test vehicle according to claim 3, wherein the vehicle control unit is further configured to control the motor control unit and the generator control unit to operate in a normal manner upon determining that the low-frequency voltage signal is normal.

5. The system for controlling safe power supply of a range-extended electric vehicle test vehicle according to claim 1, wherein the battery management system is configured to acquire a low-frequency voltage signal from the low-voltage power supply line, and upon determining that the low-frequency voltage signal is abnormal, disconnect a battery pack relay of the test vehicle to cut off a connection between a power battery of the test vehicle and a high-voltage wiring harness of the test vehicle.

6. The system for controlling safe power supply of a range-extended electric vehicle test vehicle according to claim 5, wherein the battery management system is further configured to maintain a closed state of the battery pack relay to maintain the connection between the power battery and the high-voltage wiring harness upon determining that the low-frequency voltage signal is normal.

7. The system for controlling safe power supply of a range-extended electric vehicle test vehicle according to claim 1, wherein the low-voltage power supply line is further configured to supply power to an engine management system of the test vehicle; and the vehicle control unit, the battery management system, and the engine management system are all disposed downstream of the emergency stop switch.

8. The system for controlling safe power supply of a range-extended electric vehicle test vehicle according to claim 1, wherein a key switch KL15 is also disposed on the low-voltage power supply line, the key switch KL15 is disposed upstream of the emergency stop switch, and the key switch KL15 is configured to control power supply of the low-voltage power supply line.

9. A method for controlling safe power supply of a range-extended electric vehicle test vehicle, comprising:
when the test vehicle is in operation and an emergency stop switch of the test vehicle is switched from a closed state to an open state, acquiring, by a vehicle control unit of the test vehicle, a low-frequency voltage signal from a low-voltage power supply line of the test vehicle, and, upon determining that the low-frequency voltage signal is abnormal, controlling the test vehicle to perform high-voltage shutdown, and controlling a motor control unit and a generator control unit of the test vehicle to respectively control a motor and a generator of the test vehicle to stop operating; and
when the test vehicle is in operation and the emergency stop switch of the test vehicle is switched from a closed state to an open state, acquiring, by a battery management system of the test vehicle, a low-frequency voltage signal from the low-voltage power supply line, and upon determining that the low-frequency voltage signal is abnormal, disconnecting a battery pack relay of the test vehicle to cut off a connection between a power battery of the test vehicle and a high-voltage wiring harness of the test vehicle.

10. The method for controlling safe power supply of a range-extended electric vehicle test vehicle according to claim 9, further comprising:
when the test vehicle is started and the emergency stop switch is in an open state, disconnecting, by the emergency stop switch, the low-voltage power supply line, and determining, by the vehicle control unit, that the low-frequency voltage signal is abnormal upon receiving no low-frequency voltage signal, and preventing the vehicle control unit from performing a preparatory operation and a high-voltage power-up operation; and
when the test vehicle is started and the emergency stop switch is in an open state, disconnecting, by the emergency stop switch, an interlock loop of a high-voltage line of the test vehicle, and determining, by the battery management system, that the low-frequency voltage signal is abnormal upon receiving no low-frequency voltage signal returned by the interlock loop, and preventing the vehicle control unit from performing the preparatory operation and the high-voltage power-up operation.
